# EUROPÄISCHE PATENTSCHRIFT

(11) **EP 3 186 865 B1**
(45) Veröffentlichungstag und Bekanntmachung des Hinweises auf die Patenterteilung: **18.07.2018**
(21) Anmeldenummer: 15757226.4
(22) Anmeldetag: 27.08.2015
(51) Int. Cl.: H02H 1/04, H02H 3/08, H02H 3/38, H02H 3/42, H02H 9/00, H02H 9/02, H03K 17/00, H03K 17/081, H03K 17/082

(54) **ELEKTRONISCHER SCHUTZSCHALTER**
ELECTRONIC CIRCUIT BREAKER
DISJONCTEUR DE PROTECTION ÉLECTRONIQUE

(30) Priorität: 28.08.2014 DE 102014012828
(43) Veröffentlichungstag der Anmeldung: 05.07.2017
(73) Patentinhaber: Ellenberger & Poensgen GmbH, 90518 Altdorf (DE)
(72) Erfinder: ASANZA MALDONADO, Diego Fernando, 90403 Nürnberg (DE)
(74) Vertreter: FDST Patentanwälte
(86) Internationale Anmeldenummer: PCT/EP2015/069693
(87) Internationale Veröffentlichungsnummer: WO 2016/030483

(56) Entgegenhaltungen:
- EP-A1- 2 750 293
- EP-A2- 2 403 088
- WO-A2-2012/148774
- AU-B1- 2013 205 395
- DE-A1-102005 038 124
- US-A- 5 041 940
- US-A1- 2013 332 750

## Beschreibung

Die Erfindung betrifft ein Verfahren zum Betrieb eines elektronischen Schutzschalter gemäß dem Oberbegriff des Anspruchs 1 sowie einen solchen elektronischen Schutzschalter gemäß dem Oberbegriff des Anspruchs 4 mit einem zwischen einen Spannungseingang und einen Lastausgang geschalteten Halbleiterschalter, dessen Gate-Anschluss mit einer Steuereinrichtung verbunden ist, welcher eingangsseitig ein den Laststrom repräsentierendes Signal zugeführt ist. Ein derartiges Verfahren und ein derartiger Schutzschalter sind aus der DE 10 2005 038 124 A1 bekannt.

Ein derartiger elektronischer Schalter oder Schutzschalter ist beispielsweise aus der DE 203 02 275 U1 bekannt. Der elektronische Schalter weist einen Halbleiterschalter in Form eines MOSFET (Metall-Oxid-Halbleiter-Feldeffekttransistor) auf, der zwischen einen Betriebsspannungsanschluss und einen Lastanschluss in einen Strompfad geschaltet ist. Um in einem Gleichspannungsnetz eine zuverlässige Strombegrenzung zu erreichen, wird ein von einem Stromsensor im Strompfad erfasster Messwert einem Komparatoreingang einer Regeleinrichtung zugeführt. Bei Vorliegen eines Einschaltsignals und bei einem einen Referenzwert unterschreitenden Messwert steuert die Regeleinrichtung den Halbleiterschalter auf, während bei einem den Referenzwert überschreitenden Messwert die Regeleinrichtung den Leistungstransistor zusteuert und den über diesen fließende Strom auf den Referenzwert begrenzt.

Aus der EP 1 186 086 B1 ist ein Stromverteilungssystem im Niedervoltbereich, insbesondere im 24V DC-Bereich, mit einer Anzahl von Stromkreisen mit jeweils einem elektronischen Schutzschalter als Kurzschluss- und/oder Überlastschutz bekannt. Die Stromkreise sind mittels eines getakteten Netzteils gemeinsam gespeist. Im Überlastfall erfolgt bei Überschreiten einer einstellbaren Stromschwelle, z. B. beim 1,1-Fachen des Nennstroms (I_{N}) eine Sperrung des elektronischen Schutzschalters nach Ablauf einer Verzögerungszeit, während im Kurzschlussfall zunächst eine Strombegrenzung und nach Überschreiten einer weiteren Stromschwelle (z. B. 2 x I_{N}) eine Sperrung des Schutzschalters nach Ablauf einer bestimmten Abschaltzeit erfolgt.

Aus der EP 1 150 410 A2 ist ein mittels eines Mikroprozessors über einen Auslösekreis angesteuerter elektronischer Schutzschalter bekannt, der die Energieversorgung zu einer Last mit einer Zeitverzögerung unterbricht. Zuvor oder zeitgleich erfolgt eine partielle Unterbrechung des Schutzschalters.

Eine partielle Unterbrechung eines elektronischen Schutzschalters mit mehreren Schaltblöcken, die jeweils einen elektronischen Schalter in Form eines MOSFET und einen diesen über einen gemeinsamen Mikroprozessor steuernden Komparator aufweisen, ist auch aus der EP 1 294 069 B1 bekannt. Im Falle eines Überstroms wird die Energieversorgung zur Last nach einer Zeitverzögerung unterbrochen, die auf eine partielle Untersagung des wenigstens einen Schalters folgt.

Aus der eingangs genannten DE 10 2005 038 124 A1 ist es bekannt, die Verlustleistung des Halbleiterschalters zu begrenzen, wozu anhand einer Spannungs- und Strommessung ein Leistungswert für die am Halbleiterschalter verbrauchte Leistung bestimmt und der Halbleiterschalter bei Überschreiten dieses Leistungswertes abgeschaltet wird, wobei Überlast- oder Kurzschlussfälle nur während des Dauerbetriebs des Halbleiterschalters betrachtet und berücksichtigt werden.

Aus der EP 2 403 088 A2 sind eine Steuereinheit zur Detektion eines Störlichtbogens in einem Gleichspannungssystem sowie ein Verfahren zum Betrieb der Steuereinheit bekannt. Diese ist mit einem Leistungsschalter gekoppelt und wertet im Betrieb die Signale eines ersten Spannungssensors vor dem Schalter sowie eines zweiten Spannungssensors und eines Stromsensors hinter dem Schalter aus. Babei werden die Spannungssignale sowie das Stromsignal an die Steuereinheit versendet, und anhand der Signale wird ein Treiber geregelt, welcher den Gate-Anschluss des Halbleiterschalters ansteuert. Die Steuereinheit erfasst die Anstiegsgeschwindigkeit des Stroms und vergleicht diese mit einem hinterlegten Schwellwert. Bei Überschreiten des Schwellwerts wird der Strom auf einen vorgegebenen Wert reduziert. Anschließend wird das zweite Spannungssignal ausgewertet und mit einem Schwellwert verglichen. Bei Unterschreiten dieses Schwellwertes wird der PWM-Betrieb des Treibers gestartet, und die Wellenform des Stromsignals und des zweiten Spannungssignals werden mit dem Wert einer kapazitiven Last verglichen. Eine Abweichung hiervon ist als Maß für einen Lichtbogen gewählt, bei welchem der Schalter abgeschaltet bzw. geöffnet wird.

Aus der US 2013/0332750 A1 ist eine Halbleitervorrichtung für eine gesteuerte Spannungsversorgung mit einer ersten Überstromdetektionseinheit bekannt, wobei eine Drain-Source-Spannung eines MOS-Transistors mit einer Referenzspannung verglichen und anhand des Vergleichs ein erstes Detektionssignal generiert wird. Eine zweite Überstromdetektionseinheit vergleicht den durch den Transistor fließenden Strom mit einem Referenzwert und generiert anhand des Vergleichs ein zweites Detektionssignal. Anhand dieser Detektionssignale wird der Transistor eingeschaltet, ausgeschaltet oder alternierend ein- und ausgeschaltet.

Zum Schalten insbesondere kapazitiver Lasten und/oder zu deren Schutz gegen Überstrom und Kurzschluss wird der Halbleiterschalter des elektronischen Schutzschalters als Konstantstromquelle zum Laden der Kapazität genutzt. Der Halbleiterschalter und insbesondere ein hierbei eingesetzter MOSFET muss in der Lage sein, während des Schaltens beziehungsweise im Zuge des Ladens der Kapazität die Verlustleistung in Folge des Einschaltstroms tragen können. Aufgrund dieser Situation werden elektronische Schutzschalter, insbesondere solche mit konstanter Strombegrenzung, üblicherweise mit einem überdimensionierten Halbleiterschalter (MOSFET) ausgelegt, um dieser Verlustleistung ausreichend Rechnung zu tragen. Eine derartige Dimensionierung des eingesetzten Halbleiterschalters führt jedoch zu einem erhöhten Kostenaufwand und einem entsprechend großen Raumbedarf innerhalb der Schaltung des elektronischen Schutzschalters.

Eine alternative Möglichkeit besteht darin, eine getaktete Ansteuerung des Halbleiterschalters mittels Pulsweitenmodulation (PWM) vorzunehmen. Hierdurch ist jedoch nicht nur der Ansteueraufwand erhöht. Vielmehr führt eine PWM-Ansteuerung zu Problemen im Falle induktiver Lasten.

Der Erfindung liegt die Aufgabe zugrunde, unter Vermeidung der genannten Nachteile einen möglichst effektiv arbeitenden elektronischen Schutzschalter anzugeben. Insbesondere soll hierbei ein überdimensionierter Halbleiterschalter sowie dessen aufwändige Ansteuerung vermieden werden.

Des Weiteren soll ein geeignetes Verfahren zum Betrieb eines solchen elektronischen Schutzschalters angegeben werden. Unter einem solchen Betriebsverfahren soll insbesondere ein geeignetes Ansteuerverfahren zur Steuerung und/oder Regelung des Halbleiterschalters eines solchen elektronischen Schutzschalters, insbesondere während eines Einschaltvorgangs einer Last, verstanden werden.

Bezüglich des des Betriebs- beziehungsweise Ansteuerverfahrens wird die genannte Aufgabe mit den Merkmalen des Anspruchs 1 und hinsichtlich des elektronischen Schutzschalters durch die Merkmale des Anspruchs 4 erfindungsgemäß gelöst. Vorteilhafte Ausgestaltungen und Weiterbildungen sind Gegenstand der hierauf rückbezogenen Ansprüche.

Hierzu ist vorgesehen, dass eine Steuer- oder Regeleinrichtung, die mit dem Gate-Anschluss eines zwischen einen Spannungseingang und einen Lastausgang geschalteten Halbleiterschalters verbunden ist, die Drain-Source-Spannung des Halbleiterschalter ermittelt und hieraus sowie aus dem erfassten Last- oder Halbleiterstrom (Drain-Source-Strom) ein Ansteuersignal für den Halbleiterschalter erzeugt, anhand dessen die Leistung des Halbleiterschalters kleiner oder gleich einem maximalen Leistungswert eingestellt wird.

Die Erfindung geht dabei von der Überlegung aus, dass während des Ladevorgangs einer kapazitiven Last eine dynamische Strombegrenzung genutzt wird, die im Gegensatz zu einer konstanten Strombegrenzung nicht auf einen bestimmten Schwellwert festgelegt, sondern abhängig vom aktuellen Wert der Drain-Source-Spannung des Halbleiterschalters (MOSFET) ist und sich dynamisch mit der Maßgabe ändert, dass das Verhältnis zwischen dem aktuell über den Halbleiterschalter fließenden Strom (Drain-Source-Strom) und der Drain-Source-Spannung stets in einem sicheren Betriebs- oder Operationsbereich des Halbleiterschalters gehalten wird. Die Stromsteuerung kann hierbei mit analogen Mitteln oder unter Verwendung eines Mikroprozessors erfolgen.

Da aufgrund dieser aktiven Stromsteuerung die Verlustleistung des Halbleiterschalters kontrolliert gesteuert werden kann, kann der Halbleiterschalter hinsichtlich der zu beherrschenden Verlustleistung entsprechend kleiner dimensioniert sein. Da zudem eine derartige Leistungssteuerung des Halbleiterschalters praktisch unabhängig von der Wellenform des Ansteuersignals ist, können auch induktive Lasten sicher geschaltet und geschützt werden.

Die Drain-Source-Spannung des Halbleiterschalters kann entweder direkt ermittelt oder aus verfügbaren Spannungswerten abgeleitet werden. So wird vorteilhafterweise die Drain-Spannung des Halbleiterschalters oder die Eingangsspannung des elektronischen Schutzschalters sowie die Source-Spannung des Halbleiterschalters oder die ausgangsseitige Lastspannung des elektronischen Schutzschalters erfasst und als entsprechender Spannungswert der Steuereinrichtung zugeführt. Diese ermittelt hieraus, insbesondere durch Differenzbildung, die Drain-Source-Spannung des Halbleiterschalters.

Der zur Leistungseinstellung des Halbleiterschalters, insbesondere während eines Einschaltvorgangs des elektronischen Schutzschalters, herangezogene Strommesswert entspricht aufgrund der Reihenschaltung des Halbleiterschalters mit der Last dem über diese fließenden Laststrom, der mittels eines Stromsensors im Strompfad des Halbleiterschalters und der Last erfasst wird. Die Leistungseinstellung des Halbleiterschalters erfolgt dann durch Bildung des Produkts aus der erfassten bzw. ermittelten Drain-Source-Spannung und dem Laststrom. Dabei wird der Halbleiterschalter über dessen Gate-Anschluss derart angesteuert, dass dessen Leistung kleiner oder gleich einem bestimmten, maximalen Leistungswert ist, beispielsweise 50 W.

Vorteilhafterweise ist der elektronische Schutzschalter zusätzlich mit einer konstanten Strombegrenzung ausgeführt, um den über die Last fließenden Strom im Überlast- und/oder Kurzschlussfall auf einen bestimmten, vorgegebenen Stromschwellwert zu begrenzen.

Nachfolgend wird ein Ausführungsbeispiel der Erfindung anhand einer Zeichnung näher erläutert. Darin zeigen:

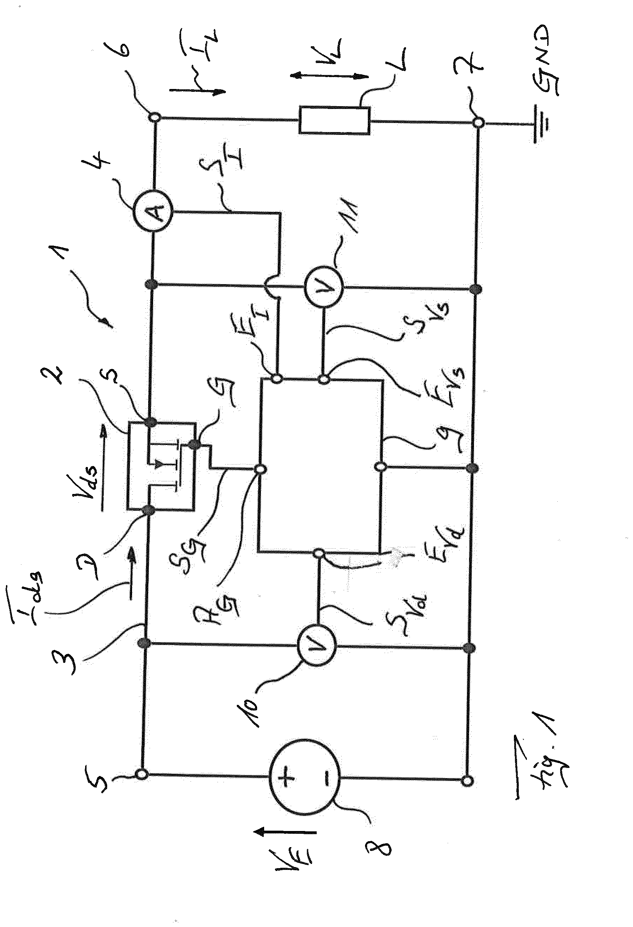

- Fig. 1: in einem Blockschaltbild einen elektronischen Schutzschalter mit einem im Pluspfad einer Stromsteuerung liegenden gesteuerten Halbleiterschalter sowie mit einer zu dessen Leistungssteuerung vorgesehenen und eingerichteten Steuereinrichtung in Form beispielsweise eines Mikroprozessors,
- Fig. 2: in einem Strom-/Spannungs-Zeit-Diagramm den Verlauf des Laststrom und der Lastspannung in Folge der Leistungssteuerung des Halbleiterschalters während eines Einschaltvorgangs einer, insbesondere kapazitiven, Last im Falle eines stufen- oder treppenförmigen Stromanstiegs, und
- Fig. 3: in einem Diagramm gemäß Fig. 2 den Strom- und Spannungsverlauf im Falle eines rampenartigen Stromanstiegs.

Einander entsprechende Teile und Parameter sind in allen Figuren mit den gleichen Bezugszeichen versehen.

Der schematisch dargestellte elektronische Schutzschalter 1 umfasst einen Leistungstransistor oder Halbleiterschalter 2 in Form eines MOSFET, dem in einem Strompfad 3, nämlich dem Pluspfad des Schutzschalters 1 ein Stromsensor 4 nachgeschaltet ist. Der Strompfad 3 erstreckt sich zwischen einem Betriebsspannungsanschluss oder Spannungseingangs 5 und einem positiven Lastanschluss 6. An diesen wird der Pluspol einer zu schaltenden Last L angeschlossen, während deren Minuspol an einen entsprechenden negativen Lastanschluss 7 des Schutzschalters 1 anzuschließen ist. Dieser Anschluss 7 ist um Ausführungsbeispiel gegen Ground GND geführt. Die von einer Strom- oder Spannungsquelle eines Netzteils 8 erzeugte Betriebs- oder Eingangsspannung V_{E} in Form beispielsweise einer Gleichspannung mit 24 V (DC) wird an den Spannungseingang 5 des elektronischen Schutzschalters 1 angelegt.

Bei angeschlossener Spannungsquelle 8 und angeschlossener Last L fließt beim Betrieb des Schutzschalters 1 ausgehend vom Spannungseingang 5 über den Strompfad 3 und somit über die Drain-Source-Strecke des Halbleiterschalters 2 sowie über die Last L ein Laststrom I_{L} gegen Bezugspotential oder Ground GND ab. Dieser über den Halbleiterschalter 2 und die Last L fließende Laststromstrom I_{L} wird mittels des Stromsensors 4 erfasst. Der erfasste Strom I_{L}, der aufgrund der Reihenschaltung des Halbleiterschalters 2 und der Last L dem über den Halbleiterschalter 2 fließenden Drain-Source-Strom I_{ds} entspricht, wird als Stromsignal S_{I} an einen ersten Eingang E_{I} einer Steuereinrichtung 9 geführt.

Anhand dieser Strommessung kann der Halbleiterschalter im Rahmen einer konstanten Strombegrenzung mittels der Steuereinrichtung derart angesteuert werden, dass im Überlast- oder Kurschlussfall der Laststrom I_{L} zumindest kurzzeitig auf einen vorgegeben maximalen Stromwert begrenzt wird. Dieser beträgt beispielsweise dem 1,1-fachen des Nennstroms I_{N} im Überlastfall. Im Kurzschlussfall kann dieser maximalen Stromwert beispielsweise dem 2-fachen des Nennstroms I_{N} betragen. Bei nur einem Schwellwert für den Überlast- und Kurzschlussfall kann der maximale Stromwert beispielsweise das 1,5-fachen des Nennstroms I_{N} betragen.

Der Steuereinrichtung 9 wird zudem ein erstes Spannungssignal S_{Vd} über einen zweiten Eingang E_{Vd} zugeführt. Diese, mittels eines ersten Spannungssensors 10 erfasste Spannung entspricht beim Ausführungsbeispiel sowohl der Eingangs- oder Betriebsspannung V_{E} als auch der Drain-Spannung V_{d} des Halbleiterschalters 2 an dessen Drain-Anschluss D.

Der Steuereinrichtung 9 wird zudem ein zweites Spannungssignal S_{Vs} zugeführt. Hierbei handelt es sich im Ausführungsbeispiel um sowohl die Source-Spannung Vₛ am Source-Anschluss S des Halbleiterschalters 2 als auch um die Lastspannung V_{L}. Das wiederum von einem entsprechenden, zweiten Spannungssensor 11 erfasste Spannungssignal Vₛ wird einem dritten Eingang E_{Vs} der Steuereinrichtung 9 zugeführt.

Die Steuereinrichtung 9 ermittelt aus den erfassten Spannungswerten V_{d} und Vₛ sowie aus dem erfassten Drain-Source-Strom I_{ds}, der dem mittels des Stromsensors 4 erfasste Laststrom I_{L} entspricht, gemäß der Beziehung P_{FET} = (V_{d} - Vₛ) · I_{ds} die aktuelle Leistung P_{FET} des Halbleiterschalters 2 und stellt diese durch dynamische Strombegrenzung des Last- und Halbleiterstroms I_{L} (= I_{ds}) derart durch entsprechende Begrenzung dieses Stromes I_{ds} ein, dass die Leistung P_{FET} einen bestimmten, maximalen Leistungswert Pₘₐₓ nicht überschreitet. Dieser Leistungswert ist beispielsweise Pₘₐₓ = 50 W, welcher durch die entsprechende dynamische Ansteuerung des Halbleiterschalters 2 allenfalls erreicht, jedoch nicht überschritten wird. Hierzu generiert die Steuereinrichtung 9 ein entsprechendes Steuersignal S_{G}, dass an einem Ausgang A_{G} der Steuereinrichtung 9 abgreifbar und an den Gate-Anschluss G des Halbleiterschalters 2 geführt ist.

Aufgrund dieser dynamischen Strombegrenzung, Stromsteuerung oder Stromregelung des Halbleiterschalters 2 mittels der Steuereinrichtung 9 durch Erfassung und Auswertung der Drain-Source-Spannung V_{ds} des Halbleiterschalters 2 und des über diesen fleißenden Stroms I_{ds} sowie in Folge der entsprechenden Leistungsbegrenzung des Halbleiterschalters 2 auf einen Leistungswert P_{FET} kleiner oder gleich Pmax kann ein vergleichsweise leistungsschwacher Halbleiterschalter 2 eingesetzt werden.

Während nämlich beim Stand der Technik zur Implementierung eines 10A-Schutzschalters (I_{N} = 10A) mit einer normalen Verlustleistung von weniger als 5W dieser aufgrund der Einschalteffekte bei kapazitiven Lasten mit einem 300W-MOSFET ausgerüstet werden müsste, kann mittels der erfindungsgemäßen Leistungssteuerung durch dynamische Strombegrenzung ein wesentlich geringer dimensionierter MOSFET als Halbleiterschalter 2 eingesetzt werden.

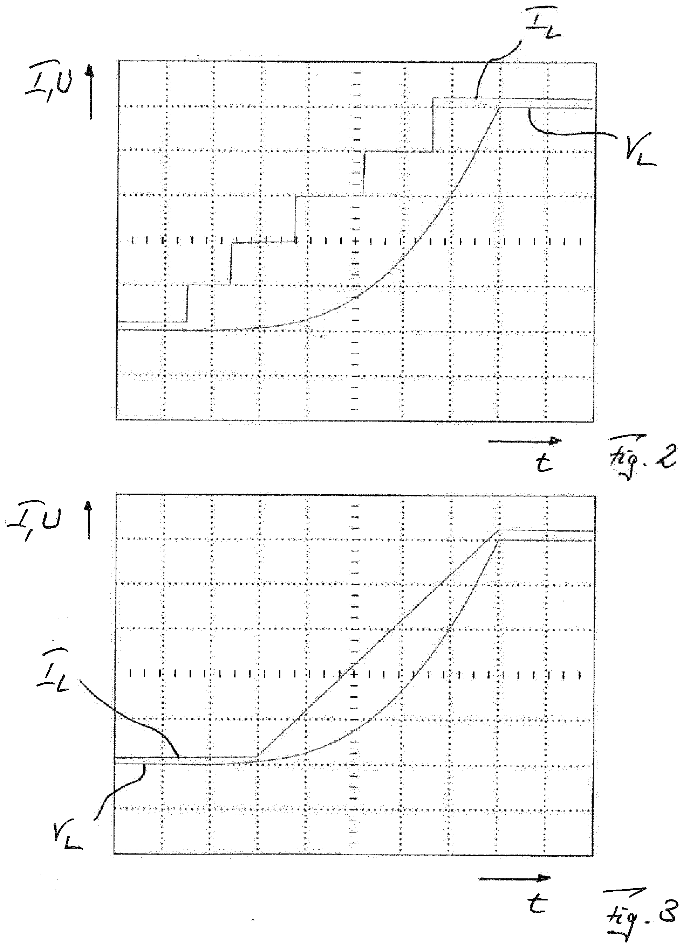

Fig. 2 zeigt in einem Strom-/Spannungs-Zeit-Diagramm den Verlauf des Laststrom I_{L} und der Lastspannung V_{L} in Folge der Leistungssteuerung des Halbleiterschalters 2 während eines Einschaltvorgangs einer kapazitiven Last L in Folge des entsprechend eingestellten Ansteuersignals S_{G} des Hableiterschalters 2 im Falle eines stufen- oder treppenförmigen Anstiegs des Laststroms I_{L} Fig. 3 zeigt die Situation im Falle eines rampenartigen Stromanstiegs.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

### Bezugszeichenliste

- 1: elektronischer Schutzschalter
- 2: Halbleiterschalter
- 3: Strom-/Pluspfad
- 4: Stromsensor
- 5: Spannungseingang
- 6: Lastanschluss (plus)
- 7: Lastanschluss (minus, ground)
- 8: Spannungsquelle/Netzteil
- 9: Steuereinrichtung
- 10: erster Spannungssensor
- 11: zweiter Spannungssensor

- A_{G}: Ausgang
- D: Drain-/Anschluss
- E_{I}: erster Eingang
- E_{Vd}: zweiter Eingang
- E_{Vs}: dritter Eingang
- G: Gate-/Anschluss
- GND: Ground/Bezugspotential
- L: Last
- S: Source-/Anschluss
- S_{I}: Stromsignal
- S_{Vd}: erstes Spannungssignal
- S_{Vs}: zweites Spannungssignal
- S_{G}: Ansteuersignal
- I_{ds}: Halbleiter-/Drain-Source-Strom
- I_{L}: Laststrom
- I_{N}: Nennstrom
- V_{E}: Betriebs-/Eingangsspannung
- V_{d}: Drainspannung
- Vₛ: Sourcespannung
- V_{ds}: Drain-Source-Spannung
- P_{FET}: Halbleiterleistung
- Pₘₐₓ: Leistungswert/Maximalleistung

## Patentansprüche

1. Verfahren zum Betrieb eines elektronischen Schutzschalters (1) mit einem zwischen einen Spannungseingang (5) und einen Lastausgang (6) geschalteten Halbleiterschalter (2), dem ansteuerseitig ein aus dem Laststrom (I_{L}, I_{ds}) und aus der Drain-Source-Spannung (V_{ds}) abgeleitetes Steuersignal (S_{G}) zugeführt wird,
**dadurch gekennzeichnet, dass** die Leistung (P_{FET}) des Halbleiterschalters (2) während des Einschaltvorgangs einer Last (L) kleiner oder gleich einem maximalen Leistungswert (Pₘₐₓ) eingestellt wird.

2. Verfahren nach Anspruch 1,
**dadurch gekennzeichnet, dass** die Drain-Source-Spannung (V_{ds}) des Halbleiterschalters (2) aus der Drain- oder Eingangsspannung (V_{d}, V_{E}) und aus der Source- oder Lastspannung (Vₛ, V_{L}) ermittelt wird.

3. Verfahren nach Anspruch 1 oder 2,
**dadurch gekennzeichnet, dass** der Halbleiterschalter (2) derart angesteuert wird, dass im Überlast- und/oder Kurzschlussfall der Laststrom (I_{L}) auf einen Schwellwert (Imₐₓ) begrenzt wird.

4. Elektronischer Schutzschalter (1) mit einem Halbleiterschalter (2), dessen Drain-Anschluss (D) und dessen Source-Anschluss (S) zwischen einen Spannungseingang (5) und einen Lastausgang (6) geschaltet sind, und dessen Gate-Anschluss (G) mit einer Steuereinrichtung (9) verbunden ist, welcher eingangsseitig ein den Laststrom (I_{L}, I_{ds}) repräsentierendes Signal (S_{I}) zugeführt ist, wobei die Steuereinrichtung (9) den Halbleiterschalter (2) in Abhängigkeit von der Drain-Source-Span (V_{ds}) und dem erfassten Laststrom (I_{L}, I_{ds}) steuert,
**dadurch gekennzeichnet**,
die Steuereinrichtung (9) ein die Leistung (P_{FET}) des Halbleiterschalters (2) während des Einschaltvorgangs einer Last (L) kleiner oder gleich einem maximalen Leistungswerts (Pₘₐₓ) einstellendes Steuersignal (S_{G}) an den Gate-Anschluss (G) des Halbleiterschalters (2) führt.

5. Elektronischer Schutzschalter (1) nach Anspruch 4,
**dadurch gekennzeichnet,**
**dass** der Steuereinrichtung (9) ein die Drain-Spannung (V_{d}) und ein die Source-Spannung (Vₛ) des Halbleiterschalters (2) repräsentierendes Spannungssignal (S_{Vd}, S_{Vs}) zugeführt sind.

6. Elektronischer Schutzschalter (1) nach Anspruch 4 oder 5,
**dadurch gekennzeichnet,**
**dass** die Steuereinrichtung (9) eingangsseitig mit einem die Eingangsspannung (V_{E}) und/oder die Drain-Spannung (V_{d}) des Halbleiterschalters (2) erfassenden Spannungsmesser (10) und mit einem die Lastspannung (V_{L}) und/oder die Source-Spannung (Vₛ) des Halbleiterschalters (2) erfassenden Spannungsmesser (11) verbunden ist.

7. Elektronischer Schutzschalter (1) nach Anspruch 5 oder 6,
**dadurch gekennzeichnet,**
**dass** die Steuereinrichtung (9) die Drain-Source-Spannung (V_{ds}) des Halbleiterschalters (2) aus der Differenz der erfassten Drain- oder Eingangsspannung (V_{d}, V_{E}) und der erfassten Source- oder Lastspannung (Vₛ, V_{L}) ermittelt.

8. Elektronischer Schutzschalter (1) nach einem der Ansprüche 4 bis 7,
**dadurch gekennzeichnet,**
**dass** die Steuereinrichtung (9) in Abhängigkeit vom erfassten Laststrom (I_{L}) den Halbleiterschalter (2) derart ansteuert, dass im Überlast- und/oder Kurzschlussfall der Laststrom (I_{L}) auf einen Schwellwert (Iₘₐₓ) begrenzt ist.

9. Elektronischer Schutzschalter (1) nach einem der Ansprüche 4 bis 8,
**dadurch gekennzeichnet,**
**dass** der Halbleiterschalter (2) ein Feldeffekttransistor, insbesondere ein MOSFET, ist, dessen Drain-Anschluss (D) dem Spannungseingang (5) und dessen Source-Anschluss (S) dem Lastausgang oder -anschluss (6) zugeordnet ist.

## Claims

1. Method for operating an electronic circuit breaker (1) having a semiconductor switch (2) connected between a voltage input (5) and a load output (6), to which a control signal (S_{G}) derived from the load current (I_{L}, I_{ds}) and from the drain-source voltage (V_{ds}) is supplied on the control side,
**characterised in that**
the power (P_{FET}) of the semiconductor switch (2) is adjusted during the switch-on process of a load (L) to be less than or equal to a maximum power value (Pₘₐₓ).

2. Method according to claim 1,
**characterised in that**
the drain-source voltage (V_{ds}) of the semiconductor switch (2) is determined from the drain or input voltage (V_{d}, V_{E}) and from the source or load voltage (Vₛ, V_{L}).

3. Method according to claim 1 or 2,
**characterised in that**
the semiconductor switch (2) is controlled in such a way that the load current (I_{L}) is limited to a threshold value (Imₐₓ) in the event of an overload or short-circuiting.

4. Electronic circuit breaker (1) having a semiconductor switch (2), whose drain terminal (D) and whose source terminal (S) are switched between a voltage input (5) and a load output (6), and whose gate terminal (G) is connected to a control device (9) to which a signal (S_{I}) representing the load current (I_{L}, I_{ds}) is supplied on the input side, wherein the control device (9) controls the semiconductor switch (2) depending on the drain-source voltage (V_{ds}) and the detected load current (I_{L}, I_{ds}),
**characterised in that**
the control device (9) guides a control signal (S_{G}) on the gate terminal (G) of the semiconductor switch (2), said signal (S_{G}) adjusting the power (P_{FET}) of the semiconductor switch (2) during the switch-on process of a load (L) to be less than or equal to a maximum power value (Pₘₐₓ).

5. Electronic circuit breaker (1) according to claim 4,
**characterised in that**
a voltage signal (S_{Vd}, S_{Vs}) representing the drain voltage (V_{d}) and a voltage signal (S_{Vd}, S_{Vs}) representing the source voltage (Vₛ) of the semiconductor switch (2) are supplied to the control device (9).

6. Electronic circuit breaker (1) according to claim 4 or 5,
**characterised in that**
the control device (9) is connected on the input side to a voltmeter (10) detecting the input voltage (V_{E}) and/or the drain voltage (V_{d}) of the semiconductor switch (2) and to a voltmeter (11) detecting the load voltage (V_{L}) and/or the source voltage (Vₛ) of the semiconductor switch (2).

7. Electronic circuit breaker (1) according to claim 5 or 6,
**characterised in that**
the control device (9) determines the drain-source voltage (V_{ds}) of the semiconductor switch (2) from the difference of the detected drain or input voltage (V_{d}, V_{E}) and the detected source or load voltage (Vₛ, V_{L}).

8. Electronic circuit breaker (1) according to one of claims 4 to 7,
**characterised in that**
the control device (9) controls the semiconductor switch (2) depending on the detected load current (I_{L}) in such a way that the load current (I_{L}) is limited to a threshold value (Iₘₐₓ) in the event of an overload or short-circuiting.

9. Electronic circuit breaker (1) according to one of claims 4 to 8,
**characterised in that**
the semiconductor switch (2) is a field-effect transistor, in particular a MOSFET, whose drain terminal (D) is assigned to the voltage input (5) and whose source terminal (S) is assigned to the load output or load terminal (6).

## Revendications

1. Procédé pour faire fonctionner un disjoncteur électronique (1) comportant un commutateur à semi-conducteur (2) connecté entre une entrée de tension (5) et une sortie de charge (6), auquel est appliqué, côté commande, un signal de commande (S_{G}) dérivé du courant de charge (I_{L}, I_{ds}) et de la tension drain-source (V_{ds}), **caractérisé en ce que** la puissance (P_{FET}) du commutateur à semi-conducteur (2) est réglée pour être inférieure ou égale à une valeur de puissance maximale (Pₘₐₓ) lors de la mise sous tension d'une charge (L).

2. Procédé selon la revendication 1, **caractérisé en ce que** la tension drain-source (V_{ds}) du commutateur à semi-conducteur (2) est déterminée à partir de la tension de drain ou d'entrée (V_{d}, V_{E}) et de la tension de source ou de charge (Vₛ, V_{L}).

3. Procédé selon la revendication 1 ou 2, **caractérisé en ce que** le commutateur à semi-conducteur (2) est commandé de telle sorte qu'en cas de surcharge et/ou de court-circuit, le courant de charge (I_{L}) est limité à une valeur seuil (Iₘₐₓ).

4. Disjoncteur électronique (1) comportant un commutateur à semi-conducteur (2) dont la borne de drain (D) et la borne de source (S) sont connectées entre une entrée de tension (5) et une sortie de charge (6), et dont la borne de grille (G) est raccordée à un dispositif de commande (9) auquel est appliqué, côté entrée, un signal (S_{I}) représentant le courant de charge (I_{L}, I_{ds}), le dispositif de commande (9) commandant le commutateur à semi-conducteur (2) en fonction de la tension drain-source (V_{ds}) et du courant de charge (I_{L}, I_{ds}) mesuré, **caractérisé en ce que** l'unité de commande (9) amène à la borne de grille (G) du commutateur à semi-conducteur (2) un signal de commande (S_{G}) pouvant régler la puissance (PFET) du commutateur à semi-conducteur (2) à une valeur inférieure ou égale à une valeur de puissance maximale (Pmax) lors de la mise sous tension d'une charge (L).

5. Disjoncteur électronique (1) selon la revendication 4, **caractérisé en ce qu'**un signal de tension (S_{Vd}) représentant la tension de drain (V_{d}) et un signal de tension (S_{Vs}) représentant la tension de source (Vs) du commutateur à semi-conducteur (2) sont appliqués au dispositif de commande (9).

6. Disjoncteur électronique (1) selon la revendication 4 ou 5, **caractérisé en ce que** le dispositif de commande (9) est relié, côté entrée, à un voltmètre (10) mesurant la tension d'entrée (V_{E}) et/ou la tension de drain (V_{d}) du commutateur à semi-conducteur (2) et à un voltmètre (11) mesurant la tension de charge (V_{L}) et/ou la tension de source (Vₛ) du commutateur à semi-conducteur (2).

7. Disjoncteur électronique (1) selon la revendication 5 ou 6, **caractérisé en ce que** le dispositif de commande (9) détermine la tension drain-source (V_{ds}) du commutateur à semi-conducteur (2) à partir de la différence entre la tension de drain ou d'entrée mesurée (V_{d}, V_{E}) et la tension de source ou de charge mesurée (Vₛ, V_{L}).

8. Disjoncteur électronique (1) selon l'une des revendications 4 à 7, **caractérisé en ce que** le dispositif de commande (9) commande le commutateur à semi-conducteur (2) en fonction du courant de charge mesuré (I_{L}) de telle sorte qu'en cas de surcharge et/ou de court-circuit, le courant de charge (I_{L}) est limité à une valeur seuil (Iₘₐₓ).

9. Disjoncteur électronique (1) selon l'une des revendications 4 à 8, **caractérisé en ce que** le commutateur à semi-conducteur (2) est un transistor à effet de champ, en particulier un MOSFET, dont la borne de drain (D) est affectée à l'entrée de tension (5) et dont la borne de source (S) est affectée à la sortie de charge ou la borne de charge (6).
